Europäisches Patentamt

European Patent Office

Office européen des brevets

(19)

(11) EP 0 851 472 A2

(12) EUROPEAN PATENT APPLICATION

(43) Date of publication:
01.07.1998 Bulletin 1998/27

(51) Int Cl.⁶: H01L 21/311

(21) Application number: 97310519.0

(22) Date of filing: 23.12.1997

(84) Designated Contracting States:
AT BE CH DE DK ES FI FR GB GR IE IT LI LU MC NL PT SE
Designated Extension States:
AL LT LV MK RO SI

(30) Priority: 23.12.1996 US 34344 P

(71) Applicant: TEXAS INSTRUMENTS INCORPORATED
Dallas Texas 75265 (US)

(72) Inventors:
• Yang, Ming
  Richardson, Texas 75082 (US)
• Li, Lei
  Richardson, Texas 75082 (US)

(74) Representative: Darby, David Thomas et al
Abel & Imray
Northumberland House
303-306 High Holborn
London WC1V 7LH (GB)

(54) **Method for etching oxide during the fabrication of an integrated circuit**

(57) The manufacture of ULSI devices such as 256 Megabit DRAMs is significantly improved by adding $CO_2$ to the oxide etch chemistry of $CHF_3$ and $CF_4$. The carbon dioxide promotes polymerization near the edge of the plasma on large (300mm) wafers during formation of oxide posts 120 that are used in manufacturing DRAMs having storage cells of the "crown" cell type.

Fig.6

**Description**

FIELD OF THE INVENTION

The invention relates generally to the field of integrated circuits, and relates more particularly to a method for etching oxide during the fabrication of an integrated circuit.

BACKGROUND OF THE INVENTION

Making an integrated circuit require numerous steps of building up and removing various layers on a semiconductor wafer. Oxide is a common insulator used in the manufacture of integrated circuits. The oxide must be appropriately patterned to form the circuits. Etching is a common method to pattern oxide. The following United States Patents assigned to Texas Instruments Incorporated, relate to etching oxide: US 4,461,672 issued July 24, 1982 entitled "Process for etching Tapered Vias in Silicon Dioxide"; US 4,654,112 issued March 31, 1987 entitled "Oxide Etch"; US 4,711,698 issued December 8, 1987 entitled "Silicon Oxide Thin Film Etching Process"; and US 4,749,440 issued June 7, 1988 entitled "Gaseous Process and Apparatus for Removing Films from Substrates".

A book entitled "Plasma Etching and Introduction" by Daniel L. Flam copyright 1989 by Academic Press International discusses etching in general. On pages 159-165 and 359-370, it particularly discusses oxide etching. The table on page 369 reflects that an etch gas of $CF_4$ with an addent of $CHF_3$ is suitable While such chemistry has been suitable in the past for devices manufactured on 0.5 micron feature sizes, such as 16 inegabit dynamic random access memory (DRAMs ), such chemistries are unsuitable for larger DRAM devices such as 64 megabit DRAM having smaller feature sizes as about 0.25 microns.

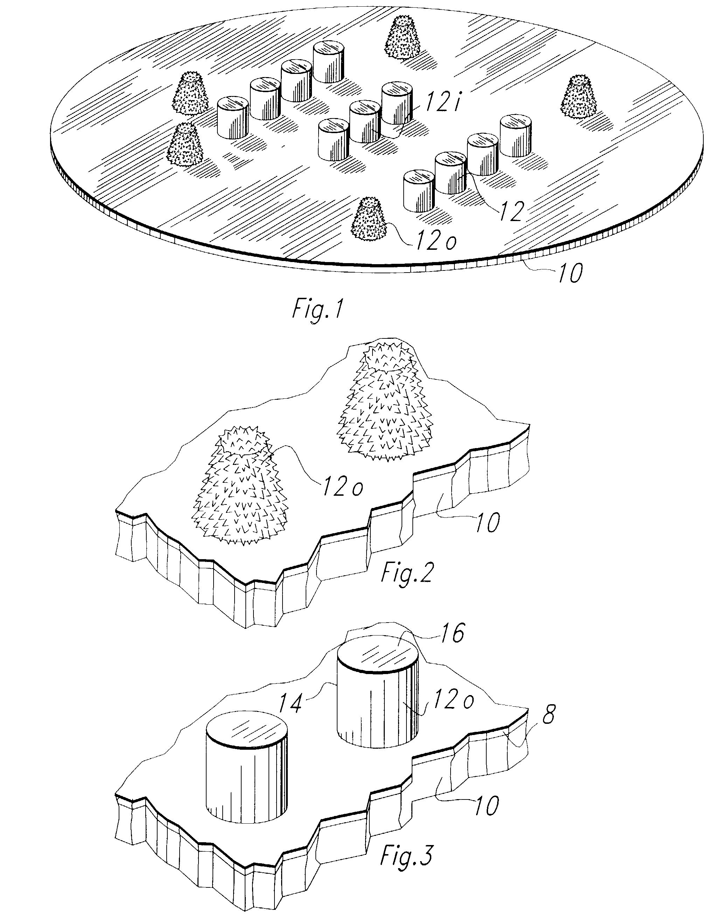

FIG. 1 depicts a silicon wafer 10 having oxide posts 12 formed with the $CF_4$/$CHF_3$ chemistry. Such wafer would typically be an eight inch wafer etched in a commercially available reactor such as an Applied P5000. As reflected in FIG. 1, posts 12o near the outer edge of semiconductor wafer 10, have jagged edges while posts 12i nearer the interior of wafer 10 have rounded edges. The jagged edges on post 120 are referred in the industry as "mouse bites". Mouse bits are undesirable because they cause many problems in fabricating DRAM cells and particularly cells of the "crown" type. The edges of post 12 need to be as smooth as possible, which the mouse bits are not, and the edges need to be a vertical as possible. Fig. 2 shows two post 120 from a side view. In addition to not being smooth, the post are not vertical, but rather are tapered.

It is believed that mouse bits are attributable to the etch chemistry, the gas dynamic at the water surface and the electric field being different near the outer edge of wafer 10 as opposed to the center of the wafer as some plasma turbulence may exist due to the relatively large wafer size. What is needed is an etch chemistry suitable for patterning extremely small feature sizes on large wafers that eliminates mouse bites and produces oxide posts with vertical profiles.

It is accordingly an object of the invention to provide a new oxide etch chemistry. Other objects and advantages of the invention maybe apparent to those of ordinary skill in the art, having the benefit of the following specification and drawings.

SUMMARY OF THE INVENTION

An inventive silicon oxide etch chemistry adds carbon dioxide, $CO_2$, to the standard oxide etch chemistry of $CF_4$ + $CHF_3$ to improve etched feature profile. Substantially vertical oxide post without mousebits may be obtained on large wafers.

BRIEF DESCRIPTION OF THE DRAWINGS

The present invention will now be further described by way of example, with reference to the accompanying drawings in which:

FIGURE 1 shows a silicon wafer having oxide posts formed with a $CF_4$,/$CHF_3$ chemistry;
FIGURE 2 shows a side elevational view of the posts of Figure 1.
FIGURE 3 shows outer oxide posts formed according to the method of the invention; and
FIGURES 4 to 6 illustratively demonstrate the method of the invention.

DETAILED DESCRIPTION OF THE EMBODIMENTS

FIG. 3 depicts outer oxide posts 120 formed in accordance with the inventive etch chemistry. The posts 120 are approximately 5000 Å tall and spaced about 0.2 microns from each other. The edges 14 are substantially vertical and the tops 16 are substantially flat; critical dimension bias is less than about 0.02mm. No mousebits exist and the profile is excellent. FIG. 3 depicts that the posts 12o are formed on a polysilicon layer 18 on silicon wafer 10. Such arrangement may be utilized in the manufacture of integrated circuits of the DRAM type and may be particularly useful in forming those memory cell structures of the crown type.

The inventive etch chemistry consists of $CF_4 + CHF_3 + CO_2 + Ar$. Unlike the prior art chemistry of $CF_4 + CHF_3 + Ar$, the inventive etch chemistry adds carbon dioxide $CO_2$. The $CO_2$ balances polymer formation at the edges 14 without blockinq the vertical (anisotropic) direction of the etch. It is believed that the chemical reaction is:

$$CF_4 + e^- \rightarrow CF_3 + F + e^-$$

$$CF_3 + e^- \rightarrow CF_2 + F + e$$

$$CF_4 + e \rightarrow CF_3^+ + F + 2e$$

$$O_2 + e \rightarrow O + O + e^-$$

$$CF_4 + O_2 \rightarrow CF_2O + 2F$$

$$CF_3 + O \rightarrow CF_2O + F$$

$$CO_2 + e^- \rightarrow CO^+ + O + O^-$$

$$CO^+ \rightarrow C + O^+ + e$$

$$C + F \rightarrow (CF)_n \text{ polymer}$$

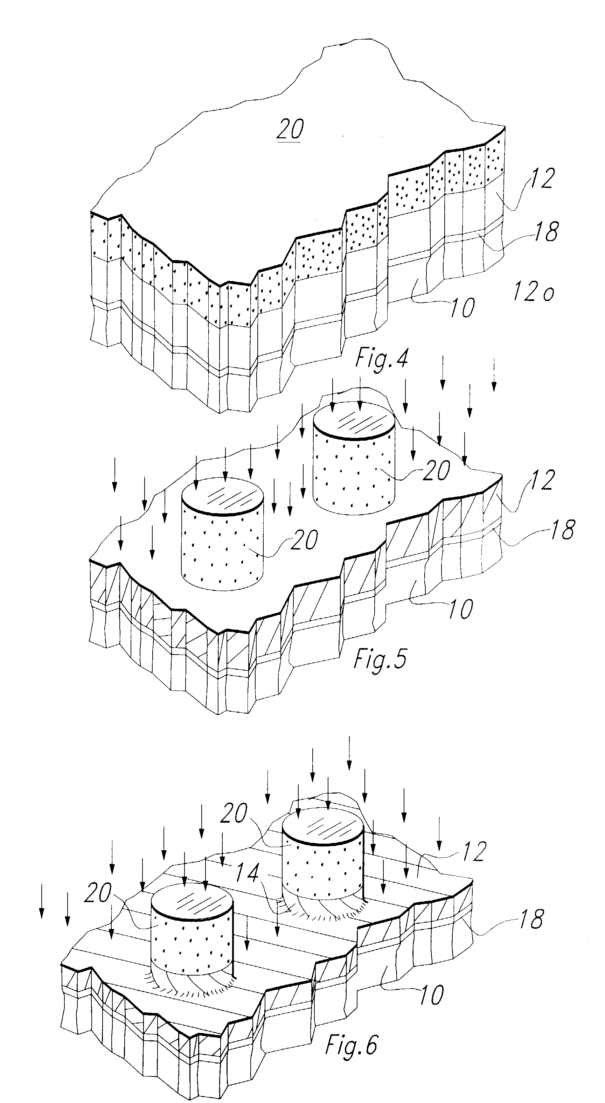

FIG.s 4-6 illustrate successive manufacturing steps in forming oxide posts 120 of FIG. 3. In FIG. 4, a masking layer 20 of photoresist overlies oxide layer 12. Oxide layer 12 overlies polysilicon layer 18 on semiconductor wafer 10. The photoresist layer 20 is about 1.1MM thick and the oxide layer 12 is about 5000 Å thick. The wafer 10 in this example is an 8 inch wafer.

In FIG. 5, the photoresist layer 20 is appropriately patterned and the wafer is placed into an etcher. Any commercially available etcher, such as the P 5000 manufactured by Applied Materials, for example, is suitable. Etch settings for both main etch and overetch follow when used in the P 5000:

|  | Main | Overetch |
| --- | --- | --- |
| $CO_2$ | 20 sccm | 20 sccm |
| $CHF_3$ | 80 sccm | 80 sccm |
| $CF_4$ | 15 sccm | 15 sccm |
| Ar | 65 sccm | 65 sccm |
| RF Power | 550 watts | 400 watts |
| Pressure | 110 mtorr | 110 mtorr |
| Time (endpoint) | 235 seconds | 40% of endpoint time |

For the main etch, all conditions may be varied by about plus or minus 10% while still receiving the superior results. Too much power, however, lowers the etch selectivity with respect to polysilicon and enhances photoresist erosion. Similarly, the overetch conditions may be varied by about the same amount while the pressure however, may be varied by about plus or minus 15%.

FIG. 6 illustrates the etch in progress. The carbon promotes polymer formation along the sidewalls 14 while the oxygen tends to reduce polymer formation. The overall inventive etch chemistry balances polymer formation while achieving anisotropy. $CO_2$ provides more carbon in the reaction chamber which will reduce the photoresist etch rate, and in the meantime it also balances the polymer formation. Mousebites are eliminated because by adding $CO_2$ in the plasma will also change the plasma potential, therefore, it modifies the electric fiield at edge of the plasma or the so called expanded plasma.

While the invention has been described with reference to illustrative embodiments, this description is not intended to be construed in a limiting sense. Various other embodiments of the invention will be apparent to persons skilled in the art upon reference to this description. For example, various carbon/oxygen etch chemistries include combinations such as $CO_2/CF_4/CHF_3/Ar$, $CO/CF_4/CHF_3/Ar$, $CO/O_2/CHF_3/Ar$, and $CO_2/CHF_3/Ar$. It is contemplated that the appended claims will cover the above embodiments and any such modifications as fall within the true scope and spirit of the invention.

## Claims

1.  A method of making an integrated circuit comprising the steps of:

    forming an oxide layer on a substrate;
    forming a photoresist layer on the oxide layer; and
    subjecting the oxide layer and the photoresist layer to a plasma etch chemistry including $CHF_3$ and a carbon/oxygen additive.

2.  The method of Claim 1, wherein the carbon/oxygen additive is $CO_2$.

3.  The method of Claim 1, wherein the carbon/oxygen additive is CO.

4.  The method of Claim 2 or Claim 3, wherein the plasma etch chemistry additionally includes $CF_4$.

5.  The the method of Claim 3 or Claim 4, where the plasma etch chemistry additionally includes $O_2$.

Fig.1

Fig.2

Fig.3

Fig.4

Fig.5

Fig.6